# EUROPEAN PATENT APPLICATION

(11) **EP 2 642 175 A1**
(43) Date of publication of application: **25.09.2013**
(21) Application number: 12173785.2
(22) Date of filing: 27.06.2012
(51) Int. Cl.: F21K 99/00, H01L 33/50, H01L 33/52, H01L 21/56, F21Y 105/00, F21Y 101/02

(54) **Luminaire and manufacturing method of the same**

(30) Priority: 19.03.2012 JP 2012062524
(71) Applicant: Toshiba Lighting & Technology Corporation, Yokosuka-shi Kanagawa 237-8510 (JP)
(72) Inventor: Hayashida, Yumiko, Kanagawa, 237-8510 (JP); Shibusawa, Soichi, Kanagawa, 237-8510 (JP); Nakagawa, Yuiko, Kanagawa, 237-8510 (JP)
(74) Representative: Bokinge, Ole

(57) **Abstract**

According to one embodiment, a luminaire includes plural semiconductor light sources (30) mounted on a board (20, 60), sealing bodies (45, 70) provided on the respective semiconductor light sources (30), and a light color adjusting part (55, 57, 59, 80, 90) to adjust light color emitted from the plural sealing bodies (45, 70). The sealing bodies (45, 70) contain a phosphor excited by a primary light emitted from the semiconductor light sources (30). The light color adjusting part (55, 57, 59, 80, 90) contains the phosphor and is provided between arbitrary adjacent sealing bodies (45, 70), or is provided by causing a shape or a characteristic of an arbitrary sealing body (57, 59, 90) among the plural sealing bodies to be different from another sealing body.

## Description

### FIELD

Embodiments described herein relate generally to a luminaire and a manufacturing method of the same.

### BACKGROUND

A luminaire using a semiconductor light source has low power consumption and long life. Thus, the luminaire rapidly comes into wide use as a luminaire for replacing a fluorescent lamp or an incandescent lamp. For example, a luminaire in which a blue light-emitting diode (LED) as the semiconductor light source is sealed with resin is small and easy to handle, and a desired light color can be obtained by selecting a phosphor contained in the resin.

As a specific form, a Chip-On-Board (COB) type luminaire in which plural LED chips are mounted on a board becomes mainstream. A manufacturing process of the COB type luminaire uses, for example, a method in which a bank surrounding LEDs is provided on the board and a sealing resin is poured therein, or a method in which a sealing resin is potted on the respective LED chips. However, in the method of using the bank, the bank which does not emit light limits a luminous intensity distribution characteristic, and light extracting efficiency may be reduced. On the other hand, in the method of potting the sealing resin, it is difficult to suppress the fluctuation of light-emitting color. Then, a luminaire is required in which a desired light characteristic can be stably obtained at a low cost.

### BRIEF DESCRIPTION OF THE DRAWINGS

FIGS. 1A and 1B are schematic sectional views showing a luminaire of a first embodiment.
FIGS. 2A to 2C are plan views schematically showing light-emitting parts of the luminaire of the first embodiment.
FIGS. 3A to 3C are plan views schematically showing light-emitting parts of a modified example of the first embodiment.
FIG. 4 is a plan view schematically showing a light-emitting part of the modified example of the first embodiment.
FIG. 5 is a flowchart showing a manufacturing process of the luminaire of the first embodiment.
FIG. 6 is a schematic sectional view showing a light-emitting part of a luminaire of a second embodiment.
FIGS. 7A to 7C are plan views schematically showing the light-emitting parts of the luminaire of the second embodiment.
FIGS. 8A to 8C are plan views schematically showing light-emitting parts of a modified example of the second embodiment.

### DETAILED DESCRIPTION

In general, according to one embodiment, a luminaire includes plural semiconductor light sources mounted on a board, sealing bodies provided on the respective semiconductor light sources, and a light color adjusting part to adjust light color emitted from the plural sealing bodies. The sealing bodies contain a phosphor excited by a primary light emitted from the semiconductor light sources. The light color adjusting part contains the phosphor and is provided between arbitrary adjacent sealing bodies, or is provided by causing a shape or a characteristic of an arbitrary sealing body among the plural sealing bodies to be different from that of another sealing body.

Hereinafter, embodiments will be described with reference to the drawings. Incidentally, the same portion in the drawings is denoted by the same reference numeral to suitably omit the detailed description thereof, and a different portion will be described.

### First Embodiment

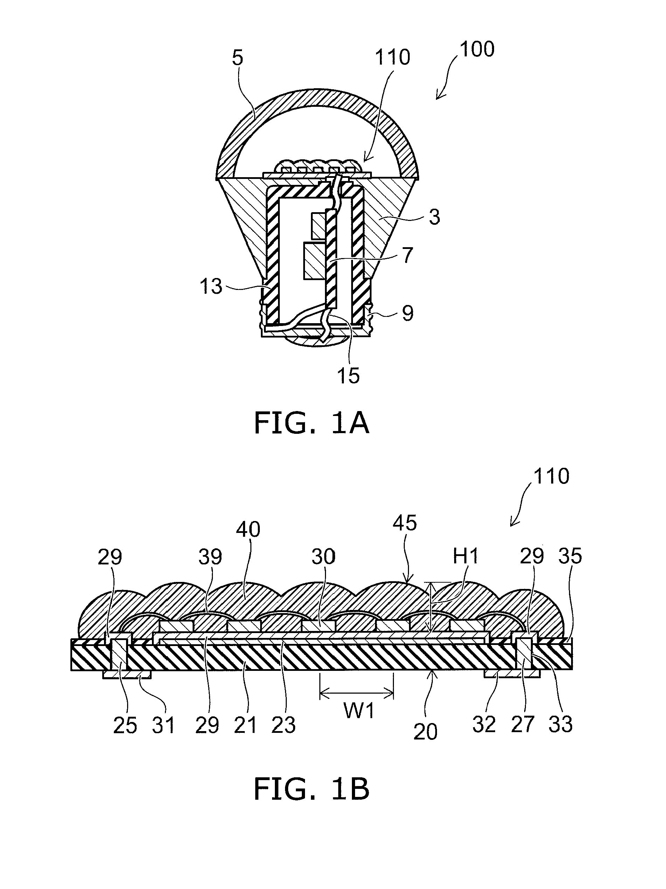

FIG. 1A is a schematic sectional view showing a luminaire 100 of a first embodiment. As shown in the drawing, the luminaire 100 is, for example, a bulb-type lamp, and includes a light-emitting part 110, a housing 3, and a cover 5 covering the light-emitting part 110.

A power conversion part 7 to supply power to the light-emitting part 110 is provided inside the housing 3, and is electrically connected to the light-emitting part 110 and a cap 9 through a lead wire 15. The power conversion part 7 is housed in an insulating case 13 provided inside the housing 3.

The power conversion part 7 is supplied with AC power from not-shown commercial power supply through the cap 9, converts the power into, for example, DC power and supplies the power to the light-emitting part 110.

As shown in FIG. 1B, the light-emitting part 110 includes plural semiconductor light sources 30 mounted on a board 20, and a sealing part 40 to seal the semiconductor light sources 30. The sealing part 40 contains a phosphor excited by a primary light emitted from the semiconductor light sources 30, and includes wavelength converting parts 45 provided on the respective plural semiconductor light sources 30. As the sealing part 40, for example, the phosphor is dispersed in an organic or inorganic matrix. As the organic matrix, for example, resin can be named.

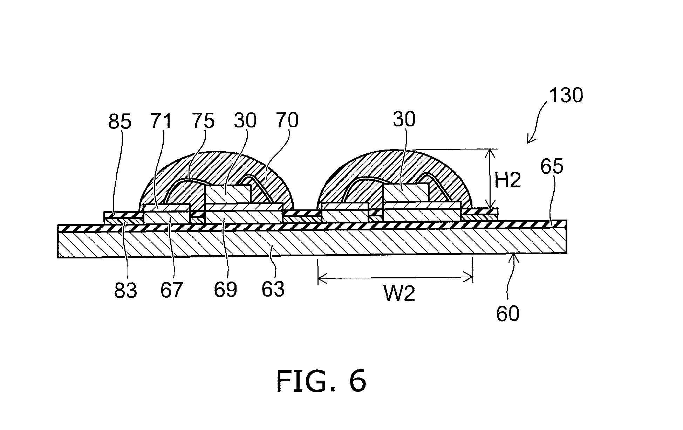

Here, the wavelength converting part is a thick portion of the sealing part 40 (for example, resin) sealing the semiconductor light source 30, and is a portion where wavelength conversion of the primary light is performed by the phosphor. However, the wavelength conversion of the primary light by the phosphor is not performed only in the wavelength converting part. Besides, the sealing part including the wavelength converting part may be such that as shown in the embodiment, sealing bodies 70 (see FIG. 6) to seal the semiconductor light sources 30 are provided to be close to each other and are mutually connected to form a continuous body, or as described later, the sealing bodies 70 to seal the semiconductor light sources 30 are provided separately from each other, and each of them is the wavelength converting part.

The board 20 includes an insulating base member 21, a thermal radiating layer 23 selectively provided on an upper surface of the base member 21, conductive layers 25 and 27, and an insulating reflecting layer 35. The thermal radiating layer 23 and the conductive layers 25 and 27 are, for example, copper foils, and silver plating layers 29 are formed on surfaces thereof. The silver plating layer 29 reflects upward the primary light from the semiconductor light source 30 and fluorescent light emitted by the phosphor contained in the sealing part 40. The reflecting layer 35 is provided around the thermal radiating layer 23 and the conductive layers 25 and 27. Besides, the reflecting layer 35 is, for example, a white resist, and reflects upward the primary light from the semiconductor light source 30 and the fluorescent light emitted by the phosphor.

The semiconductor light source 30 is, for example, a blue LED chip made of a GaN nitride semiconductor and formed on a sapphire board, and is mounted on the thermal radiating layer 23. Each semiconductor light source 30 includes a not-shown p-electrode and n-electrode on an upper surface thereof, and is electrically connected to each other through a metal wire 39.

The conductive layers 25 and 27 are respectively a positive electrode and a negative electrode, and are electrically connected to the semiconductor light source 30 through the metal wire 39. For example, the conductive layers 25 and 27 are connected to back electrodes 31 and 32 via through-holes 33 provided in the base member 21. The electrodes 31 and 32 are connected to the power conversion part 7 through the lead wire 15.

The semiconductor light sources 30 are supplied with the DC power from the power conversion part 7 through the conductive layers 25 and 27, and respectively emit blue light. The phosphor contained in the sealing body 40 is, for example, YAG phosphor (Yttrium Aluminum Garnet phosphor), is excited by the blue light emitted by the semiconductor light sources 30, and emits yellow fluorescent light.

The sealing part 40 is such that for example, resin containing silicone as its main component is mixed with phosphor, and is potted on each of the plural semiconductor light sources 30. The sealing part 40 has thixotropy, and preferably has a Shore hardness D40 or higher after hardening. By this, the sealing part 40 can be provided to have a specific shape. Besides, deformation by outer force is suppressed, and breaking of the metal wire 39 can be prevented.

For example, the section of the potted sealing part 40 perpendicular to the upper surface of the board 20 has a dome shape between a triangle and a semicircle. In this embodiment, the semiconductor light sources 30 are mounted at high density, and an arrangement interval (arrangement pitch) W1 thereof is narrow. Thus, resins potted on the semiconductor light sources 30 are mutually connected, and the sealing part 40 is provided to have a continuous shape including the wavelength converting parts 45 corresponding to the positions of the semiconductor light sources 30.

For example, a ratio (that is, an aspect ratio) obtained by dividing a height H1 of the wavelength converting part 45 from the upper surface of the board 20 by the arrangement pitch W1 of the semiconductor light sources 30 is preferably 0.2 or more and 1.0 or less. By this, a luminous intensity distribution angle is widened and a color difference between side and front can be reduced.

Further, the sealing part 40 contacts the reflecting layer 35 provided around the thermal radiating layer 23 and the conductive layers 25 and 27. For example, an adhesion force of the sealing part 40 to the silver plating layer 29 is low as compared with the reflecting layer 35 formed of ceramic or resin and is liable to be peeled. Thus, an outer peripheral part of the sealing part 40 is made to adhere to the reflecting layer 35, so that the adhesion strength can be enhanced, and peeling from the board 20 can be suppressed.

Besides, a resin having low gas permeability is preferably used as the sealing part 40. For example, the silver plating layer 29 may react with sulfur or moisture in the outer air and is blackened. By this, the reflectance to the primary light from the semiconductor light source and the fluorescent light is reduced, and the light output (light flux maintaining ratio) is reduced. Accordingly, it is desirable that the sealing part 40 covering the silver plating layer 29 shuts off the outer air and suppresses the blackening.

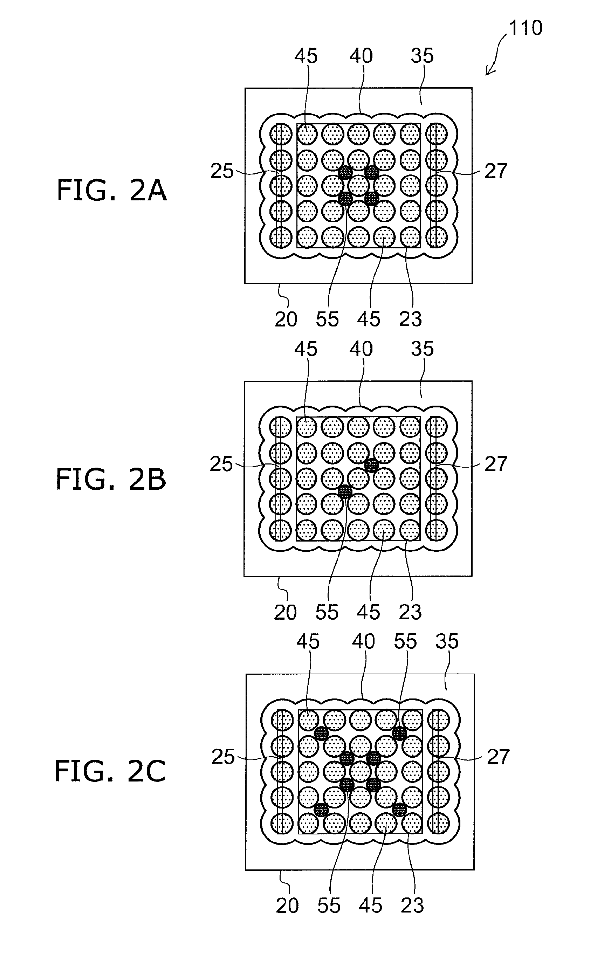

FIG. 2A to FIG. 2C are plan views schematically showing the light-emitting part 110 of the first embodiment. The sealing part 40 provided on the board 20 includes the wavelength converting parts 45 and light color adjusting parts 55. The light color adjusting part 55 adjusts the color of outgoing light in which the primary light from the semiconductor light source 30 and the fluorescent light emitted by the phosphor are mixed. The light color adjusting part 55 contains, for example, the same resin as the wavelength converting part 45 as its main component.

FIG. 2A is a plan view showing a standard arrangement (first sealing part) of the wavelength converting parts 45 and the light color adjusting parts 55. As shown in the drawing, the sealing part 40 covers the thermal radiating layer 23 and the conductive layers 25 and 27, and an outer edge thereof contacts the reflecting layer 35. The wavelength converting parts 45 correspond to the positions of the semiconductor light sources 30 mounted on the thermal radiating layer 23, and are formed into, for example, a matrix shape. The light color adjusting parts 55 are provided at positions deviating from the regularity of the arrangement of the wavelength converting parts 45. Besides, as shown in FIG. 2A, the light color adjusting parts 55 are provided at the center part of the sealing part 40.

The light color adjusting parts 55 can be formed by potting the resin containing the phosphor in spaces between the adjacent semiconductor light sources 30. The light color adjusting part 55 contains the phosphor emitting fluorescent light with a longer wavelength than the blue light emitted by the semiconductor light source 30. Besides, in the standard arrangement shown in FIG. 2A, although four light color adjusting parts 55 are provided at the center part of the sealing part 40, no limitation is made to this example, and an arbitrary number of light color adjusting parts 55 may be provided in an arbitrary arrangement.

FIG. 2B and FIG. 2C show arrangement examples (second sealing part) of the light color adjusting parts 55 after color adjustment is performed. For example, if the color temperature of the outgoing light in the standard arrangement is lower than a specific value, as shown in FIG. 2B, the number of the light color adjusting parts 55 arranged at the center part of the sealing part 40 is reduced, so that the amount of phosphor is reduced and the color temperature is raised. For example, as shown in FIG. 2B, if two light color adjusting parts 55 are provided, the light color adjusting parts are preferably provided on a diagonal line in a plane arrangement of the semiconductor light sources 30.

On the other hand, if the color temperature of the outgoing light in the standard arrangement is higher than the specific value, as shown in FIG. 2C, in addition to the light color adjusting parts 55 arranged at the center part of the sealing part 40, the light color adjusting parts 55 are provided also at a peripheral part. By this, the amount of the phosphor is increased and the color temperature can be lowered. Also in this case, the light color adjusting parts 55 are preferably provided on the diagonal line in the plane arrangement of the semiconductor light sources 30.

The light color adjusting parts 55 are arranged at the center part of the sealing part 40 and are provided on the diagonal line in the plane arrangement of the semiconductor light sources 30, so that the emitted light from the light-emitting part 110 becomes uniform, and the color difference between side and front can be reduced.

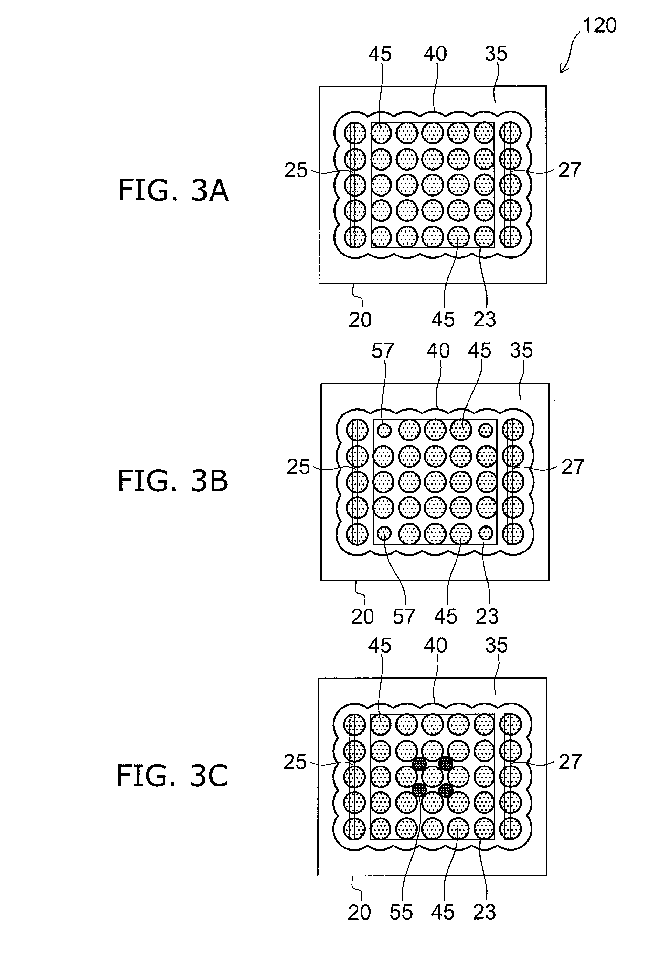

FIG. 3A to FIG. 3C are plan views schematically showing a light-emitting part 120 of a modified example of the first embodiment.

FIG. 3A is a plan view showing a standard arrangement of the wavelength converting parts 45. The sealing part 40 covers the thermal radiating layer 23 and the conductive layers 25 and 27, and the outer edge thereof contacts the reflecting layer 35. The wavelength converting parts 45 are formed into, for example, a matrix shape. Besides, the standard arrangement shown in FIG. 3A does not include the light color adjusting part 55.

For example, when the color temperature of outgoing light in the standard arrangement is lower than a specific value, as shown in FIG. 3B, the amount of resin of wavelength converting parts 57 arranged at the periphery of the sealing part 40 is reduced, so that the amount of phosphor is reduced and the color temperature is raised.

As shown in FIG. 3B, the wavelength converting parts 57 are preferably provided on a diagonal line in the plane arrangement of the semiconductor light sources 30. Besides, the wavelength converting parts 57 containing a small amount of phosphor are preferably provided at the peripheral part in the plane arrangement of the semiconductor light sources. By this, uniformity of emitted light from the light-emitting part 120 is maintained, and the color difference between side and front can be suppressed.

On the other hand, if the color temperature of the outgoing light in the standard arrangement is higher than the specific value, as shown in FIG. 3C, the light color adjusting parts 55 are provided at the center part of the sealing part 40, so that the amount of phosphor is increased and the color temperature is reduced. Also in this case, the light color adjusting parts 55 are preferably provided on the diagonal line in the plane arrangement of the semiconductor light sources 30.

As stated above, the amount of phosphor contained in the wavelength converting parts 57 is reduced, so that the light color of the outgoing light of the light-emitting part 120 can be adjusted. Accordingly, the wavelength converting parts 57 are also one of the light color adjusting parts. The wavelength converting part 57 may be formed by potting resin in which the content of phosphor is reduced. Besides, the composition of phosphor contained in the wavelength converting part 57 may be different from that of phosphor contained in the wavelength converting part 45.

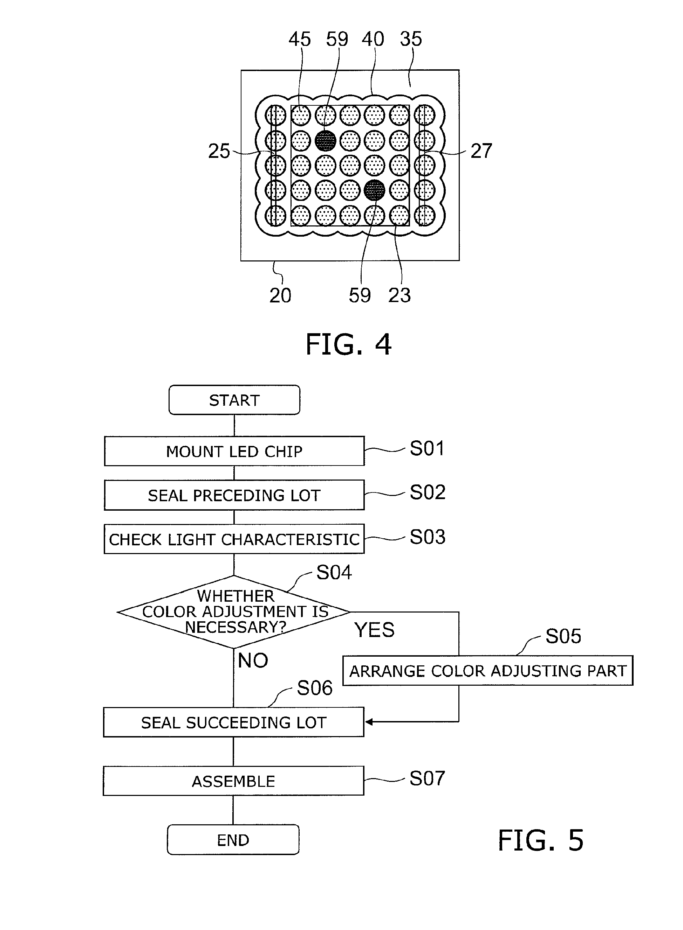

Further, as shown in FIG. 4, wavelength converting parts 59 may be provided as the light color adjusting parts. The amount or composition of phosphor contained in the wavelength converting part 59 is different from the amount or composition of phosphor contained in the wavelength converting part 45. For example, in the standard arrangement shown in FIG. 3A, if the color temperature is lower than the specific value, the wavelength converting part 59 in which the content of phosphor is small is potted instead of the wavelength converting part 45. Besides, the wavelength converting part 59 containing phosphor emitting fluorescent light having a shorter wavelength than the wavelength converting part 45 may be provided.

On the other hand, in the standard arrangement shown in FIG. 3A, if the color temperature is higher than the specific value, the wavelength converting part 59 in which the content of phosphor is large may be provided, or the wavelength converting part 59 containing phosphor emitting fluorescent light having a longer wavelength than the wavelength converting part 45 may be provided.

As stated above, in the sealing part 40, the portion including the light color adjusting part is different from the portion surrounding the light color adjusting part in at least one of the regularity of roughness, the shape of roughness, the amount of phosphor and the composition of phosphor. That is, the light color adjusting part 55 containing the phosphor may be provided between arbitrary wavelength converting parts 45, or the shape or the characteristic of an arbitrary wavelength converting part 45 may be made different from that of another wavelength converting part. By this, the light color of the light-emitting parts 110 and 120 is adjusted and the fluctuation thereof can be suppressed.

Next, a manufacturing method of the luminaire 100 will be described with reference to FIG. 5. FIG. 5 is a flowchart showing the manufacturing process of the luminaire 100.

First, the semiconductor light sources 30 are mounted on the board 20 (Act 01). Specifically, plural LED chips are fixed to a surface of the thermal radiating layer 23 by, for example, silver paste. Then, four or five LED chips are connected in series to each other through the metal wires 39 between the conductive layers 25 and 27.

Next, a proceeding lot (first board) on which the semiconductor light sources 30 are mounted is sealed (Act 02) . Specifically, the wavelength converting parts 45 and the light color adjusting parts 55 are formed according to the standard arrangement shown in FIG. 2A or FIG. 3A. Subsequently, the optical characteristic (for example, color temperature) of the preceding lot is checked (Act 03).

Next, based on the result of the light characteristic check, necessity of color adjustment is determined (Act 04). For example, if the color temperature deviates from an allowable range, and the color adjustment is determined to be necessary, the arrangement of the light color adjusting parts is determined (Act 05). If the color temperature is low, the light color adjusting part 55 is removed, and if the color temperature is high, the light color adjusting part 55 is added, and the color temperature is adjusted. By this, the preferable arrangement of the light color adjusting parts is determined, and a succeeding lot (second board) is sealed with resin (Act 06).

In the light characteristic check of the preceding lot, if the color adjustment is determined to be unnecessary, the succeeding lot is sealed with resin according to the standard arrangement. Subsequently, the light-emitting part in which the resin sealing is completed is assembled in the housing, and the luminaire 100 is completed (Act 07).

By the above manufacturing process, the luminaire in which the fluctuation of light color and the color difference between side and front are suppressed can be manufactured. Besides, if the lot in which sealing is precedently performed does not have a desired light color, the resin of the light color adjusting part is increased or decreased, so that the light color adjustment can be performed. By this, the waste of phosphor and resin is eliminated, and the manufacturing cost can be reduced.

### Second Embodiment

FIG. 6 is a schematic sectional view showing a light-emitting part 130 of a luminaire of a second embodiment. The light-emitting part 130 includes plural semiconductor light sources 30 mounted on a board 60, and sealing bodies 70 to seal the semiconductor light sources 30. The sealing bodies 70 are potted on the respective semiconductor light sources 30, and contain phosphor excited by primary light from the semiconductor light source 30. In this embodiment, the adjacent sealing bodies 70 are provided to be separated from each other. Besides, the wavelength converting part in this embodiment is the whole sealing body 70.

The board 60 includes a metal base 63, an insulating layer 65 covering an upper surface of the metal base 63, conductive layers 67 and 69 selectively provided on the insulating layer 65, and insulating reflecting layers 83 and 85. The conductive layers 67 and 69 are, for example, copper foils, and silver plating layers 71 are formed on surfaces thereof. The silver plating layer 71 reflects upward the primary light from the semiconductor light source 30 and fluorescent light emitted by the phosphor contained in the sealing body 70. The reflecting layers 83 and 85 are provided around the conductive layers 67 and 69, and reflect upward the primary light from the semiconductor light source 30 and the fluorescent light emitted by the phosphor.

The reflecting layer 83 (first layer) is, for example, a white resist, and has a high reflectivity to the primary light from the semiconductor light source 30 and the fluorescent light emitted by the phosphor. The reflecting layer 85 (second layer) is, for example, a white ceramic containing silica, and has higher adhesiveness to the sealing body 70 than the reflecting layer 83. By this, the adhesive strength of the sealing body 70 to the board 60 is improved and peeling is suppressed.

The semiconductor light source 30 is mounted on the conductive layer 69, and a p-electrode and an n-electrode on an upper surface thereof are electrically connected to the conductive layers 67 and 69 through a metal wire 75. The semiconductor light sources 30 mounted on the adjacent conductive layers 69 are electrically connected to each other by not-shown wiring.

The sealing body 70 is, for example, a resin containing silicone as its main component, and includes YAG phosphor (Yttrium Aluminum Garnet phosphor). Besides, the sealing body 70 has thixotropy, and preferably has Shore hardness D40 or higher after hardening. By this, the sealing body 70 can be provided to have a specific shape. Besides, deformation by outer force is suppressed, and breaking of the metal wire 75 can be prevented.

As shown in FIG. 6, the section of the sealing body 70 perpendicular to an upper surface of the board 60 has a dome shape between a triangle and a semicircle. For example, an aspect ratio obtained by dividing a height H2 of the sealing body 70 from the upper surface of the board 60 by a diameter W2 of the bottom thereof is preferably 0.2 or more and 1.0 or less. By this, a luminous intensity distribution angle is widened, and a color difference between side and front can be reduced.

Further, the sealing body 70 contacts the reflecting layer 85 provided around the respective conductive layers 67 and 69. By this, the adhesion strength of the sealing body 70 at an outer peripheral part is enhanced, and peeling can be prevented. Besides, a resin having low gas permeability is used as the sealing body 70. By this, blackening of the silver plating layer 71 is suppressed.

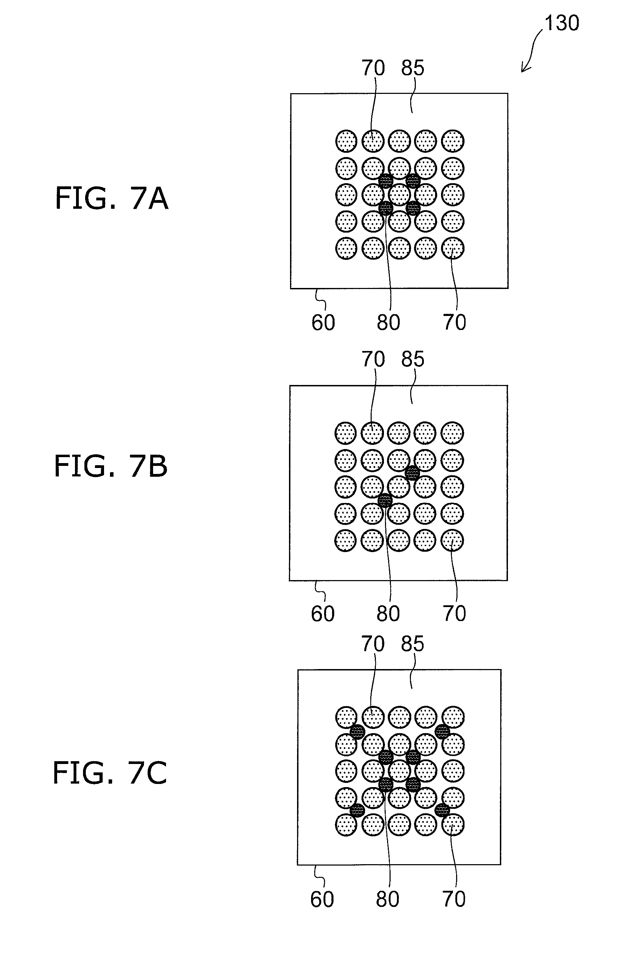

FIG. 7A to FIG. 7C are plan views schematically showing the light-emitting part 130 of the second embodiment. The sealing bodies 70 and light color adjusting parts 80 are provided on the board 60. The light color adjusting part 80 adjusts the color of outgoing light in which the primary light from the semiconductor light source 30 is mixed with the fluorescent light emitted by the phosphor contained in the sealing body 70. The light color adjusting part 80 contains, for example, the same resin as the sealing body 70.

FIG. 7A is a plan view showing a stand arrangement of the sealing bodies 70 and the light color adjusting parts 80. As shown in the drawing, the sealing bodies 70 correspond to the positions of the semiconductor light sources 30 mounted on the conductive layer 69, and are formed into, for example, a matrix shape. The light color adjusting part 80 contains phosphor to emit fluorescent light having a longer wavelength than the blue light emitted by the semiconductor light source 30. The light color adjusting parts 80 are provided at, for example, positions deviated from the regularity of the arrangement of the sealing bodies 70. Besides, the light color adjusting parts 80 are provided at the center part of the plane arrangement of the semiconductor light sources 30.

In the standard arrangement shown in FIG. 7A, although four light color adjusting parts 80 are provided at the center part of the arrangement of the sealing bodies 70, no limitation is made to this example. An arbitrary number of light color adjusting parts 80 may be provided in an arbitrary arrangement.

FIG. 7B and FIG. 7C show arrangement examples of the light color adjusting parts 80 after color adjustment is performed. For example, if the color temperature of the outgoing light in the standard arrangement is lower than a specific value, as shown in FIG. 7B, the number of the light color adjusting parts 80 is reduced, so that the amount of phosphor is reduced, and the color temperature is raised. As shown in FIG. 7B, if two light color adjusting parts 80 are provided, the light adjusting parts are preferably provided on a diagonal line in the plane arrangement of the semiconductor light sources 30.

On the other hand, if the color temperature of the outgoing light in the standard arrangement is higher than the specific value, as shown in FIG. 7C, in addition to the light color adjusting parts 80 arranged at the center part of the arrangement of the semiconductor light sources 30, the light color adjusting parts 80 are provided also at a peripheral part. By this, the amount of phosphor is increased and the color temperature can be lowered. Also in this case, the light color adjusting parts 80 are preferably provided on the diagonal line in the plane arrangement of the semiconductor light sources 30. By this, the outgoing light from the light-emitting part 130 becomes uniform, and the color difference between side and front can be suppressed.

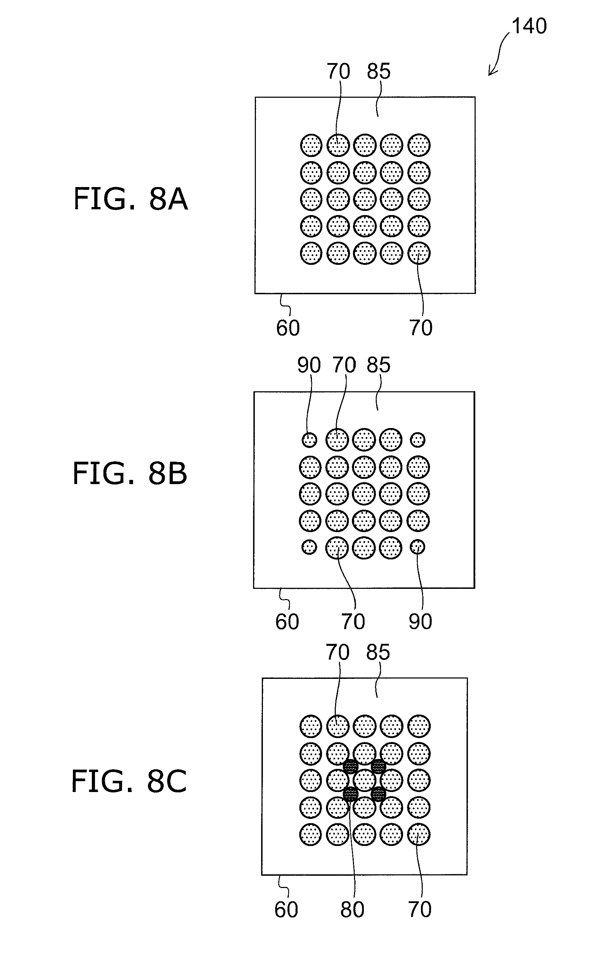

FIG. 8A to FIG. 8C are plan views schematically showing a light-emitting part 140 of a modified example of the second embodiment. FIG. 8A is a plan view showing a standard arrangement of the sealing bodies 70. FIG. 8B and FIG. 8C show arrangement examples of the light color adjusting parts 80 after color adjustment is performed.

In the standard arrangement shown in FIG. 8A, the sealing bodies 70 are formed into a matrix shape, and the light color adjusting part 80 is not included.

For example, if the color temperature of the outgoing light in the standard arrangement is lower than a specific value, as shown in FIG. 8B, the semiconductor light sources 30 arranged at an outer periphery are sealed with sealing bodies 90 in which the amount of resin is reduced. By this, the amount of phosphor is reduced, and the color temperature can be raised.

As shown in FIG. 8B, the sealing bodies 90 are preferably provided on a diagonal line in the plane arrangement of the semiconductor light sources 30. Besides, the sealing bodies 90 are preferably provided at a peripheral part in the plane arrangement of the semiconductor light sources 30. By this, uniformity of the outgoing light from the light-emitting part 140 is maintained, and the color difference between side and front can be suppressed.

On the other hand, if the color temperature of the outgoing light in the standard arrangement is higher than the specific value, as shown in FIG. 8C, the light color adjusting parts 80 are provided at the center part of the arrangement of the semiconductor light sources 30. By this, the amount of phosphor is increased and the color temperature can be lowered. Also in this case, the light color adjusting parts 80 are preferably provided on the diagonal line in the plane arrangement of the semiconductor light sources 30.

As stated above, the sealing bodies 90 in which the amount of resin is reduced are provided, so that the light color of the outgoing light of the light-emitting part 140 can be adjusted. Accordingly, the sealing bodies 90 are also one of the light color adjusting parts. Besides, the content of phosphor in the sealing body 90 may be reduced, or the composition of phosphor may be changed. As stated above, the light color adjusting part in the second embodiment is constructed by providing the irregular portion in at least one of the regularity of arrangement of the sealing bodies 70 (wavelength converting part), the shape, the amount of phosphor, and the composition of phosphor.

In the first embodiment and the second embodiment, although the description is made while using the bulb type lamp as an example of the luminaire, no limitation is made to this, and a spot light or a base light may be used. Besides, the respective components described in the first embodiment and the second embodiment are mutually combined, and can also be carried out in another form.

Although exemplary embodiments have been described, these embodiments have been presented by way of example only, and are not intended to limit the scope of the invention. Indeed, these novel embodiments can be carried out in a variety of other forms, and various omissions, substitutions and changes can be made within the scope not departing from the gist of the invention. These embodiments and modifications thereof fall within the scope and the gist of the invention and fall within the scope of the invention recited in the claims and their equivalents.

## Claims

1. A luminaire comprising:
a plurality of semiconductor light sources (30) mounted on a board (20, 60);
sealing bodies (45,70) which are provided on the respective semiconductor light sources (30), and contain a phosphor excited by a primary light emitted from the semiconductor light sources (30); and
a light color adjusting part (55, 57, 59, 80, 90) which contains the phosphor and is provided between arbitrary adjacent sealing bodies (45, 70) or is provided by causing a shape or a characteristic of an arbitrary sealing body (57, 59, 90) among the plurality of sealing bodies (45, 70) to be different from that of another sealing body, and adjusts light color emitted from the plurality of sealing bodies.

2. The luminaire of claim 1, wherein a ratio obtained by dividing a height of the sealing body (70) by a diameter of a bottom of the sealing body is 0.2 or more and 1.0 or less.

3. The luminaire of claim 1 or 2, wherein the light color adjusting part (55, 57, 59, 80, 90) is constructed by providing an irregular portion in at least one of an arrangement of the sealing bodies (45, 70), a shape, an amount of the phosphor, and a composition of the phosphor.

4. The luminaire of any one of claims 1 to 3, wherein a section of the sealing body (45, 70) perpendicular to the board (20, 60) has a dome shape.

5. The luminaire of any one of claims 1 to 4, wherein the light color adjusting part (55, 57, 59) is provided on a diagonal line in a plane arrangement of the semiconductor light sources (30).

6. The luminaire of any one of claims 1 to 5, wherein the light color adjusting part (55, 80) is provided at a center part in a plane arrangement of the semiconductor light sources (30).

7. The luminaire of any one of claims 1 to 6, wherein the light color adjusting part (57, 90) is the sealing body in which a content of the phosphor is small, and the light color adjusting part (57, 90) is provided at a peripheral part in a plane arrangement of the semiconductor light sources (30).

8. The luminaire of any one of claims 1 to 7, wherein
the board (20, 60) includes a thermal radiating layer (23) or a conductive layer (69) on which the plurality of semiconductor light sources (30) are mounted, and a reflecting layer (35, 83, 85) which is provided around the thermal radiating layer (23) or the conductive layer (69), and reflects light emitted from the semiconductor light sources (30) and the phosphor, in which adhesiveness of the sealing body (45, 70) to the reflecting layer (35, 83, 85) is higher than that to the thermal radiating layer (23) or the conductive layer (69), and
at least a part of the sealing body (45, 70) is connected to the reflecting layer (35, 83, 85).

9. A manufacturing method of a luminaire, comprising:
forming, on a first board (20) on which a plurality of semiconductor light sources (30) are mounted, a first sealing part (40, 70) containing a phosphor excited by a primary light emitted from the semiconductor light sources (30);
checking a light characteristic of the first board (20) on which the first sealing part (40, 70) is formed; and
forming a second sealing part (40, 70), based on a check result of light color emitted from the first sealing part (40, 70), on a second board (20) on which a plurality of semiconductor light sources (30) are mounted.

10. The method of claim 9, wherein the second sealing part (40, 70) in which the light color of the first sealing part (40, 70) is adjusted is formed on the second board (20), when the light color emitted from the first sealing part (40, 70) deviates from an allowable range.

11. The method of claim 9 or 10, wherein
the first sealing part (40, 70) includes wavelength converting parts (45, 70) respectively formed on the plurality of semiconductor light sources (30), and a light color adjusting part (55, 80) to adjust light color emitted from the wavelength converting parts, and
the second sealing part (40, 70) adjusts the light color by increasing or decreasing the light color adjusting part (55, 80) formed between adjacent arbitrary wavelength converting parts or by forming an arbitrary wavelength converting part (57, 59, 90) to have a shape or a characteristic different from another wavelength converting part among the wavelength converting parts (45, 70) formed on the plurality of semiconductor light sources.

12. The method of claim 9 or 10, wherein
the first sealing part (40, 70) includes wavelength converting parts (45, 70) formed on the plurality of respective semiconductor light sources, and
the second sealing part (40, 70) adjusts the light color by arranging the phosphor (55, 80) between adjacent arbitrary wavelength converting parts (45, 70) or by forming an arbitrary wavelength converting part (57, 59, 90) to have a shape or a characteristic different from another wavelength converting part among the wavelength converting parts (45, 70) formed on the plurality of semiconductor light sources.

13. The method of claim 11 or 12, wherein the light color adjusting part or the phosphor (55, 80) arranged between the wavelength converting parts is provided on a diagonal line in a plane arrangement of the semiconductor light sources (30).

14. The method of claim 11 or 12, wherein the light color adjusting part or the phosphor (55, 80) arranged between the wavelength converting parts is provided at a center part in a plane arrangement of the semiconductor light sources (30).
